# EUROPEAN PATENT SPECIFICATION

(11) **EP 1 405 333 B1**
(45) Date of publication and mention of the grant of the patent: **17.11.2010**
(21) Application number: 02741833.4
(22) Date of filing: 05.06.2002
(51) Int. Cl.: H01L 21/68, C30B 25/12, C30B 31/14, C23C 16/458

(54) **WAFER BOAT AND METHOD OF MAKING A SLIP FREE WAFER BOAT**
WAFERBOOT UND VERFAHREN ZUR HERSTELLUNG EINES RUTSCHSICHEREN WAFERBOOTS
NACELLE DE PLAQUETTES ET PROCEDE DE FABRICATION D'UNE NACELLE PORTE-PLAQUETTE NON GLISSANTE

(30) Priority: 19.06.2001 US 884720
(43) Date of publication of application: 07.04.2004
(73) Proprietor: Saint-Gobain Ceramics and Plastics, Inc., Worcester, MA 01615-0137 (US)
(72) Inventor: HENGST, Richard, R., Oakham, MA 01068 (US)
(74) Representative: Leidescher, Thomas
(86) International application number: PCT/US2002/017654
(87) International publication number: WO 2002/103759

(56) References cited:
- EP-A- 0 807 961
- JP-A- 2001 048 667
- US-A- 3 951 587
- US-A- 5 904 778
- US-A- 5 904 892
- US-A- 6 093 644
- US-A- 6 110 285
- US-B1- 6 171 400

## Description

The present invention relates to semiconductor manufacturing. More specifically, the present invention relates to wafer boats having wafer support structures, such as slots, that are coated with a protective ceramic coating and subjected to a post coating finishing process to define a wafer contact surface having a post coating surface finish for each slot.

Although other materials may be used, e.g., Silicon-Germanium (SiGe) or Galium Arsenide (GaAs), Silicon (Si) is presently the most important semiconductor for the electronics industry. Very Large Scale Integrated (VLSI) circuit technology (i.e., up to about 100,000 devices per chip), and Ultra Large Scale Integrated (ULSI) circuit technology (i.e., more than 100,000 and in some cases exceeding one billion devices per chip) being based almost entirely on silicon.

It is critical that the fabrication of VLSI and ULSI circuits which take place on silicon substrates possess very high crystalline perfection or purity. That is, in crystalline solids, the atoms which make up the solid are spatially arranged in a periodic fashion. If the periodic arrangement exists throughout the entire solid, the substance is defined as being formed of a single crystal. The periodic arrangement of the atoms in the crystal is called the lattice. Very high crystalline perfection requires that the silicon substrate possess a minimum of impurities and structural defects throughout its single crystal silicon lattice.

Generally, raw material, e.g., quartzite, is refined into electronic grade polysilicon (EGS) and melted. A silicon seed crystal is than used to grow a single crystal silicon ingot from the molten EGS. The ingot is than precisely sliced and polished into silicon wafers. The silicon wafers provide the substrates upon which VLSI and ULSI circuits are ultimately built through a complex sequence of wafer fabrication processes.

The increasing size of silicon wafers is one of the most obvious trends in silicon material technology. Presently, 300mm diameter wafers are expected to ultimately replace most 150 mm and 200 mm wafer applications. It is also predicted that 400 mm wafers will probably be introduced in the not too distant future. The use of larger diameter wafers for maintaining productivity presents several major challenges to semiconductor manufactures. For example, facilities with equipment capable of handling the larger wafers, e.g., vertical furnaces, must be built. New patterning techniques must be developed to print smaller feature sizes over larger areas. The larger wafers must also be thicker to increase their resistance to warping and other structural deformations. Moreover, the larger wafers are also heavier, requiring the use of automated wafer transport systems.

As the silicon wafers become bigger and heavier, the problem of preventing impurities and structural defects to the lattice, i.e., of maintaining very high crystalline perfection, becomes even more critical. One such structural defect, which becomes especially problematic in 300 mm silicon wafers and larger, is that of slip in the lattice structure.

Slip in silicon wafers is a function of the stress applied to the wafer. This stress can be mechanical (e.g., frictionally induced) and/or thermal. As the wafers are stressed, the crystal lattice undergoes elastic deformation that disappears as the solid crystal returns to its original position upon release of the stress. However, severe stress leads to slip, which is the plastic or permanent deformation in the crystal lattice, which remains when the stress is released. Slip occurs when the elastic limit (or yield strength) of the silicon is exceeded and the lattice becomes permanently misaligned.

Slip is common during high temperature processing of silicon wafers in heat treatment furnaces (furnacing operations), as thermal stress is proportional to the processing temperature. The transition temperature from brittle to ductile behavior of the wafer is generally within the range of about 720 to 1000 degrees C. Therefore slip, whether induced by thermal or mechanical stress, becomes especially problematic at process temperatures above 720 degrees C.

Wafer boats are wafer support devices, which are subjected to furnacing operations during semiconductor wafer processing. Horizontal wafer boats are typically designed to support a horizontal row of wafers, which are inserted into a horizontal furnace tube for high temperature processing. Vertical wafer boats are typically designed to support a vertical stack of wafers, which are inserted into a vertical furnace tube. Generally, for large diameter silicon wafers, e.g., 300mm, vertical wafer boats are more commonly used. This is because vertical furnaces have a smaller foot print than horizontal furnaces and therefore take up less of the expensive manufacturing space. Additionally, vertical furnaces generally demonstrate better temperature control than horizontal furnaces.

EP 0 807 961 A describes a vertical wafer boat including tapered supporting pieces coated by a CVD film of silicon carbide. The vertical wafer boat is prepared so that supporting groves have an inner wall with a surface roughness of no greater than 100 µm prior to CVD coating when machined by a commercially available diamond blade. JP 2001 048667 A describes joining ceramic parts by forming a CVD silicon carbide fixing coating layer thereon. The CVD-SiC fixing coating layer provides a high hardness shell on the whole outer surface of the combined ceramic parts. US 6 110 285 A describes a vertical wafer boat including support rods with wafer mount groove portions. Chamfers are formed on the opening_edges of the wafer mount grooves by a sandblast process or the like and have a surface roughness (Ra) of 0.3 to 500 µm prior to covering the support rods with a high-purity ceramic film of CVD-SiC. US 6 093 644 A describes a vertical wafer board including a plurality of support boards engaged into grooves of a plurality of poles. The upper face of each support board constitutes a loading face for a wafer. The loading face is formed as a silicon carbide film on a substrate buy applying a CVD method. The silicon carbide film is ground by a silicon carbide tool including a silicon carbide film formed by CVD on a substrate such as high purity carbon. After grinding, the silicon carbide film of a support board has a maximum surface roughness of 10 µm.

Wafer boats are generally composed of ceramic materials. Ceramic materials, which are joined by ionic or covalent bonds, are typically composed of complex compounds containing both metallic and non metallic elements. Ceramics typically are hard, brittle, high melting point materials with low electrical and thermal conductivity, good chemical and thermal stability, and high compressive strengths. Examples of ceramic materials are quartz, silicon carbide (SiC) and recrystalized SiC. One such recrystallized SiC is available from Saint-Gobain Ceramics & Plastics, Inc. of Worcester, MA, under the trade name CRYSTAR^{®}. This material is a silicon carbide ceramic that has been impregnated with high purity silicon metal.

The surfaces of the wafer boats which come into contact and support the weight of the silicon wafers are typically called wafer contact surfaces. In wafer boats designed to hold a plurality of silicon wafers, the wafer contact surfaces are typically disposed in wafer slots of the wafer boats, which are sized to receive each silicon wafer. In wafer boats designed to hold a single wafer (more commonly used for large diameter wafers) the wafer contact surfaces may be located on other structures of the wafer boats, e.g., raised wafer support pads. The frictional forces between these wafer contact surfaces and the silicon wafers during heating and cooling, i.e., thermal operations, are a source of mechanical stress, which can induce slip. Because common ceramic materials used for boats have different thermal expansion coefficients than single crystal silicon, the wafers detrimentally slide on the wafer contact surfaces during thermal cycling, thereby increasing mechanical stress and potentially inducing slip. This is especially the case for the heavier 300 mm wafers during furnacing operations which exceed 720 degrees centigrade.

Another problem associated with wafer boats is that it is very difficult and expensive to maintain the high purity levels required for electronic grade silicon processing over the entire body of the boats. That is, at high temperatures, impurities in the body of the boats, e.g. iron, copper, nickel, aluminum, sodium, calcium or the like, can migrate and contaminate the wafers. To prevent this, the boats are dimensionally built undersized and coated, via a chemical vapor deposition (CVD) process, with a protective coating of high purity ceramic such as SiC. Typically, the SiC coating is nominally 60 microns thick and must be a minimum of 30 to 40 microns thick in order to adequately prevent the migration of impurities through the coating. The purity levels required within the coating itself are generally 1 part per million (ppm) or less.

Problematically however, CVD coated boats generally have a surface finish of greater than 1.0 microns. For purposes of this application all surface finishes will be designated in microns and shall represent the standard maximum roughness height index, i.e., arithmetic average, normally designates by the symbol "Ra". For the 300 mm and larger wafers, this relatively rough surface finish can result in excessive frictional forces at the higher temperature operations, which can induce slip.

In an attempt to solve the problem of slip for the larger wafer sizes, prior art boats have been built without a CVD coating, and the wafer contact surfaces machined to a highly smooth surface finish, e.g., less than 0.4 microns, to reduce friction. However, control of the purity levels over the entire body of such boats has proven to be difficult to maintain at required levels, e.g., 1ppm or less. As a result, these prior art boats are excessively expensive. Additionally, it is questionable whether the purity of these prior art boats can meet the rigorous standards required to prevent the migration of impurities into the silicon wafers, which would compromise the wafer's very high crystalline purity.

Accordingly, there is a need for an improved wafer boat, which can minimize the frictional forces that cause slip in large diameter silicon wafers, and which maintains the purity levels required for silicon wafer processing at a reasonable cost.

The present invention offers advantages and alternatives over the prior art by providing a wafer boat having wafer support structures, e.g., slots, that are coated with a protective ceramic coating and subjected to a post coating finishing process to define a wafer contact surface having a post coating surface finish for each support structure. The ceramic coating has a predetermined thickness, which substantially prevents migration of impurities from the wafer boat to the silicon wafers being processed, i.e., an impurity migration preventing thickness. Additionally, the post coating surface finish of the wafer contact surfaces substantially prevents slip from occurring. Because only the purity of the coating has to be maintained at a very high purity level, as opposed to the entire body of the boat, the wafer boat can be manufactured at a reasonable cost.

These and other advantages are accomplished in an exemplary embodiment of the invention by providing a wafer boat for supporting silicon wafers. The wafer boat includes a ceramic body having at least one wafer support structure sized to support a silicon wafer thereon. A ceramic coating is disposed on a surface of the wafer support structure. The ceramic coating has a thickness of greater than or substantially equal to 30 microns and a wafer contact surface. The wafer contact surface has a post coating surface finish, which substantially prevents slip in the silicon wafers and is less than or substantially equal to 0.4 microns.

The wafer boat is typically a vertical wafer boat, having wafer support structures which are slots sized to receive silicon wafers of 300 mm diameter or greater. Embodiments of this invention are especially effective in preventing slip in large sized silicon wafers during thermal operations, which reach temperatures of 720 degrees centigrade or greater.

An exemplary embodiment of a method of making the invention includes a process of providing a ceramic wafer boat body having at least one wafer support structure sized to support a silicon wafer thereon. A coating process is then utilized to coat a surface of the wafer support structure with a protective ceramic coating. The protective ceramic coating is then subjected to a finishing process to define a wafer contact surface. The ceramic coating has a thickness of greater than or substantially equal to 30 microns to prevent impurity migration. Additionally, the wafer contact surface of the ceramic coating has a post coating surface finish, which substantially prevents slip in the silicon wafers and has a post coating surface finish of less than or substantially equal to 0.4 microns.

An embodiment of the coating process includes a chemical vapor deposition (CVD) process. An embodiment of the finishing process includes a machining operation and/ or a laser cutting operation.
Fig.1 is a perspective view of an exemplary embodiment of a vertical wafer boat in accordance with the present invention;
1 Fig. 2 is a side view of the wafer boat;
Fig. 3 is an enlarged view of the circular section E of Fig. 2;
Fig. 4 is a perspective view of an alternative embodiment of a wafer boat in accordance with the present invention; and
Fig. 5 is an exemplary embodiment of a manufacturing flow chart for making a wafer boat in accordance with the present invention.

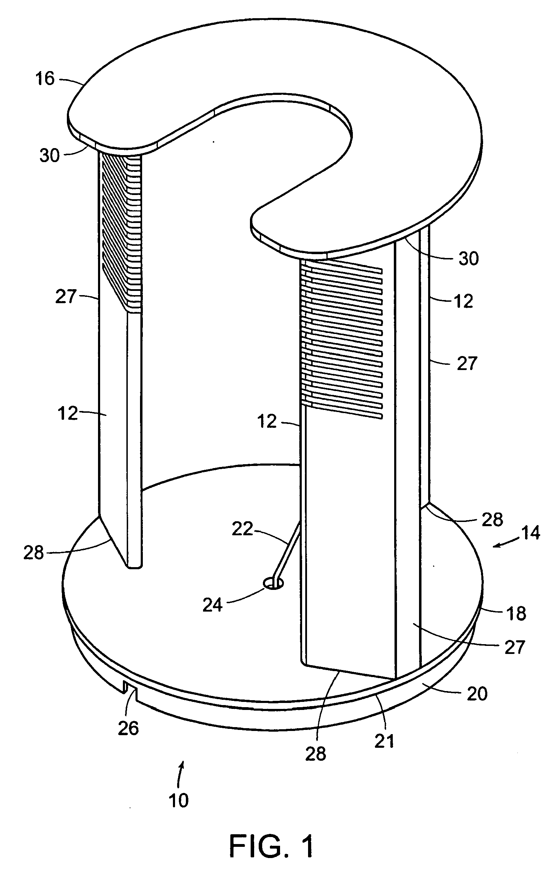

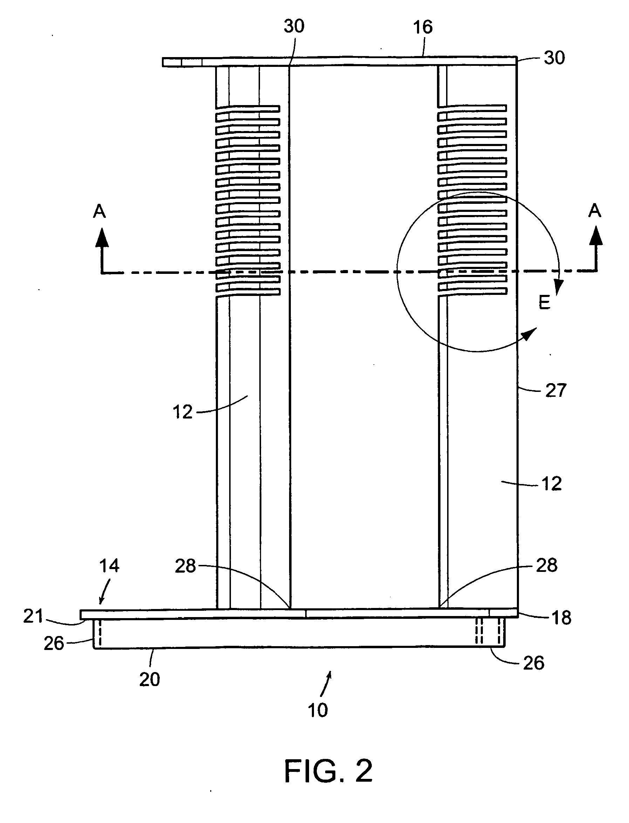

Referring to Figs. 1 and 2, a vertical wafer boat in accordance with the present invention is shown generally at 10. The entire wafer boat 10, i.e., the body of the wafer boat, is composed of cast recrystalized SiC and includes three support rods 12, a base 14 and a top plate 16.

The base 14 is generally circular in shape and includes a generally horizontal flat base plate 18 having a predetermined diameter. The base 14 also includes a vertical rim 20 extending downwardly from the lower surface of the base plate 18. The rim 20 is concentric to and smaller in diameter than the base plate 18, such that the outer periphery of the horizontal base plate 18 extends over the vertical rim 20 to define a circular lip 21. An expansion slot 22 is cut radially outward from a center hole 24. The expansion slot 22 extends through the outer periphery of the base plate 18, as well through the rim 20. The slot 22 allows for thermal expansion and contraction of the base 14 during thermal operations, e.g., a furnacing operation. The vertical rim 20 also includes a pair of rectangular locating notches 26, which correctly orient the wafer boat 10 when placed in a vertical furnace (not shown) during a furnacing operation.

The support rods 12 are elongated structures having a generally rectangular shaped cross section. The outer edges 27 of the support rods 12 are flush against the outer periphery of the base plate 18 and the support rods 12 are oriented on the base plate 18 to receive a predetermined diameter silicon wafer, e.g., 300 mm. The rods 12 are welded to the upper surface of the base plate 18 at their lower distal ends 28 and extend substantially vertically upwards therefrom.

The upper distal ends 30 of the support rods 12 are welded to the lower surface of the top plate 16, which is a U shaped flat plate that extends substantially parallel to the base plate 18. The U shape of the top plate 16 allows for expansion and contraction during high temperature thermal operations in much the same way as the expansion slot 22 does for the base 14. Though the support rods 12, base 14 and top plate 16 are described as being welded together, other assembly techniques are also within the scope to this invention, e.g., bolting, press fitting or chemically bonding the components together.

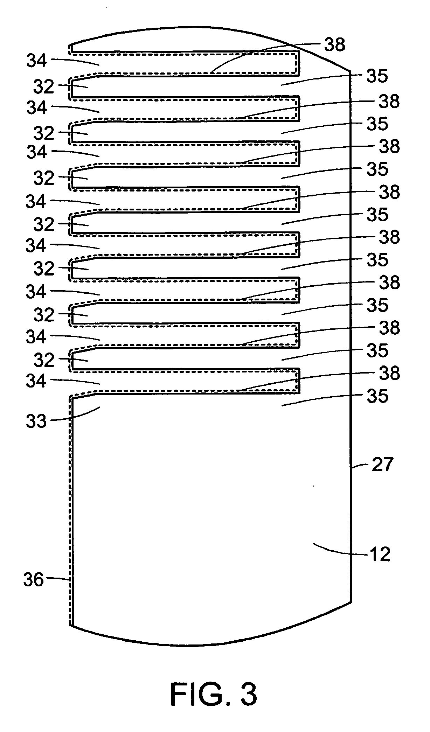

Referring to Fig. 3, the support rods 12 include a plurality of ceramic arms 32. The ceramic arms 32 include an anchored end portion 35 proximate the outer edge 27 of the support rod 12. The ceramic arms 32 extend from the anchored end portion 35 in the general direction of the center portion of the base plate 18 and generally parallel to the base plate 18. Each pair of arms 32 defines a wafer slot 34 sized to receive a silicon wafer of predetermined diameter, e.g., 300mm, and associated thickness. For purpose of this invention, an arm is to be considered any structure with a surface which contacts, and supports, the weight of a silicon wafer (wafer contact surface). Therefore, that arm portion 33 of the support rods 12 which extends below and defines the lower most slot 34, is also to be considered an arm. The wafer boat's body 10 is molded such that it is dimensionally undersized in at least its critical dimensions, e.g., the areas around the slots 34, in order to leave room for a CVD protective coating 36 of high purity SiC, e.g., less than 1 ppm. Though this embodiment describes a wafer boat having slots with wafer contact surfaces designed to hold a plurality of wafers, one skilled in the art would recognize that other structures of the wafer boats may also have wafer contact surfaces. For example, a wafer boat designed to hold a single wafer may include raised pads on a ring, in which the top surfaces of the pads are the wafer contact surfaces.

The protective coating 36 generally includes a surface finish of greater than 1.0 micron throughout the body of the wafer boat 10. However, the CVD coating 36 disposed on the lower surface of each wafer slot 34 is subjected to a post coating finishing process, e.g., machined or laser cut, to remove a predetermined amount of ceramic coating. Accordingly, this finishing process provides a protective coating on each ceramic arm 32 and 33 having a nominal thickness of approximately 60 microns. Additionally the protective coating includes a wafer contact surface 38 for each arm 32 and 33 having a post coating surface finish, i.e., a surface finish obtained from the post coating finishing process, of approximately 0.4 microns. Advantageously, the SiC protective coatings are thick enough, e.g., a minimum of 30 microns, to prevent impurities in the body of the wafer boat 10 from migrating through the coating 36 and into the silicon wafers (not shown) during a furnacing operation. Additionally, the post coating surface finish of each wafer contact surface 38 reduces the coefficient of friction between the wafer contact surface 38 and the silicon wafer to substantially eliminate the possibility of slip occurring during high temperature thermal operations, i.e., operations in which the temperature reaches 720 degrees centigrade. Though this embodiment shows the protective coating 36 being applied to the entire body of the wafer boat 10, it is within the scope of this invention to apply the protective coating 36 to just the areas around the slots 34 where the wafer contact surfaces 38 will be located.

Though a CVD protective coating of SiC is shown in this embodiment, one skilled in the art will recognize that other ceramic coatings may be used, e.g., silicon nitride (Si₃N₄). Additionally, the protective coating thickness may also vary so long as it performs its primary function of preventing impurities from migrating through to the silicon wafer, i.e., an impurity migration preventing thickness. Additionally, the post coating surface finish of the wafer contact surfaces may vary from the 0.4 microns discussed above, so long as the coefficient of friction is reduced to substantially prevent slip, especially during high temperature thermal operations.

Though the wafer boat 10 is described above as being of the vertical type, it will be clear to one skilled in the art that horizontal wafer boats are within the scope of this invention. Also, although this exemplary embodiment discusses a wafer boat sized for 300mm diameter wafers, a wafer boat in accordance with this invention may be sized for other wafer diameters as well, e.g.,150mm, 200mm, or 400mm. Additionally the wafer boat may also be composed of ceramics other than recrystallized SiC, e.g., quartz, sintered SiC, or poly-silicon.

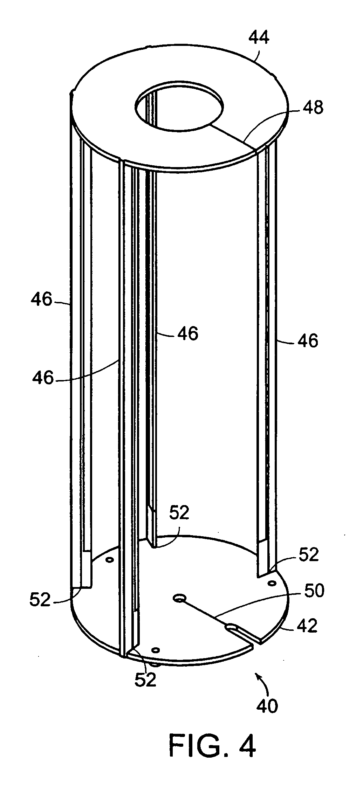

Referring to Fig. 4, an alternative embodiment of a vertical wafer boat in accordance with the present invention is shown generally at 40. In this case, wafer boat body 40 includes a base 42, a top plate 44 and a plurality of four support rods 46. Additionally, the top plate 44 is generally ring shaped and includes an expansion slot 48 to allow for expansion and contraction during high temperature thermal operations. The base 42 is generally circular shaped and includes an expansion slot 50. A set of four mounting slots 52 is formed into the outer periphery of the base 42. Upon assembly, the support rods 46 are press fit into each mounting slot 52 such that the lower distal ends of the rods 46 are flush with the bottom surface of the base 42.

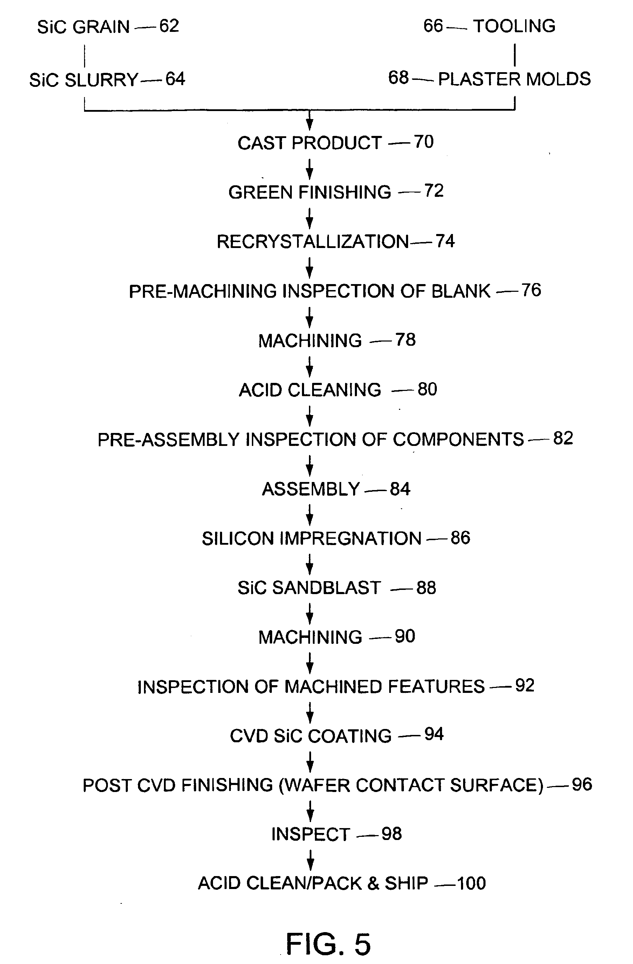

Referring to Fig. 5, a typical manufacturing process flow chart in accordance with the present invention is shown generally at 60. Raw SiC grain 62 is mixed with de-ionized water to form a SiC slurry 64. The slurry is poured into pre-prepared plaster molds 68 where it is then processed to produce the cast products at step 70. The cast products, i.e., the green (unfinished) support rods 12, base 14 and top plate 16, are then removed from the molds and are put through a green finishing operation 72, which brings the parts closer to their final net shape. After green finishing, the individual parts are subjected to a recrystallization process 74. That is the green finished parts are subjected to a high temperature firing operation wherein the ceramic grains are bonded together of sintered to form blanks. A pre-machine inspection of the blanks 76 is then performed to check for damaged or out of tolerance parts. If required, the blanks are machined 78 to provide further detailed structure and to meet proper dimensional tolerances. The unfinished parts are then cleaned in an acid bath 80 to remove impurities. A pre-assembly inspection of the components 82 is then performed on the components of the boat 10. Next the support rods 12, base 14 and top plate 16 are put through an assembly process 84, e.g., welding, bolting, press fitting or chemically bonding, to form an unfinished wafer boat 10. The wafer boat 10 is then subjected to a silicon impregnation process 86, in which the SiC ceramic wafer boat 10 is impregnated with high purity silicon metal to fill any porous cavities and bring the wafer boat 10 up to its full density. After silicon impregnation 86 the surface of the wafer boat 10 is sandblasted to remove the impurities and excess silicon 88. Since sand blasting roughens the surfaces of the wafer boat 10, the critical features of the wafer boat are then subjected to another machining operation 90 to bring the critical dimensions of the boat 10 into tolerance.

It is essential, at this point, that the ceramic boat 10 be dimensionally undersized by a predetermined amount in the critical dimensions of the boat 10, especially where the surfaces of the boat 10 come in contact with and support the silicon wafers, i.e., the wafer contact surfaces 38. This is because room must be allowed for the application of a protective coating, in this case a high purity CVD silicon carbide coating. Therefore, the machined features of the boat are subjected to an inspection process 92 to confirm the accuracy of the machining process. The CVD SiC coating 94 is then applied to prevent impurities in the body of the boat 10 from migrating into the silicon wafers. Typically the SiC coating is applied up to a 100 micron nominal thickness over the entire body of the boat 10.

Advantageously, the wafer contact surfaces 38 are subjected to a post coating finishing process 96, e.g., machining or laser cutting, which removes a predetermined amount of coating and finishes the wafer contact surfaces 38 to approximately 0.4 microns Ra (a post coating surface finish). Typically in this step 96 the protective CVD SiC coating is reduced to a thickness of 60 microns nominal. The protective coating must, in any case, have a predetermined minimum thickness in order to adequately prevent the migration of impurities. This minimum limit is generally 30 to 40 microns for CVD SiC coatings. The post coating surface finish must also be below a predetermined limit in order to reduce the coefficient of friction between the wafer contact surfaces 38 and the silicon wafers to a point which essentially prevents slip. Typically, the post coating surface finish must be at least less than 0.4 micron.

After the post coating finishing process 96, the wafer boat 10 is subjected to a final inspection 98. The finished wafer boat is then given a final acid cleaning, packaged and prepared for shipment 100.

Though the manufacturing process 60 in this embodiment has been described as primarily a casting operation, one skilled in the art would recognize that other manufacturing processes may also be utilized to manufacture the wafer boat 10. For example, the wafer boat manufacturing process may be primarily a machining, pressing or extrusion process.

It is to be understood that the present invention has been described by way of illustration and not limitation.

## Claims

1. A wafer boat (10) for supporting silicon wafers, the wafer boat comprising:
a ceramic body having at least one wafer support structure (32, 33) sized to support a silicon wafer thereon;
a ceramic coating (36) disposed on a surface of the wafer support structure, the ceramic coating having an impurity migration preventing thickness and a wafer contact surface (38) **characterized in that** the wafer contact surface has a post coating surface finish;
wherein the thickness of the ceramic coating is greater than or substantially equal to 30 microns thick, and the post coating surface finish of the wafer contact surface is less than or substantially equal to 0.4 microns.

2. The wafer boat of Claim 1 wherein the wafer support structure comprises at least one wafer slot (34) sized to receive a silicon wafer therein.

3. The wafer boat of Claim 1 wherein the post coating surface finish of the wafer contact surface substantially prevents slip in silicon wafers of 300mm diameter or greater.

4. The wafer boat of Claim 1 wherein the post coating surface finish of the wafer contact surface substantially prevents slip in silicon wafers during thermal operations reaching temperatures of 720 degrees centigrade or greater.

5. The wafer boat of Claim 1 wherein the ceramic body comprises one of quartz, silicon carbide (SiC) and recrystallized SiC.

6. The wafer boat of Claim 1 wherein the ceramic coating comprises a SiC.

7. The wafer boat of Claim 1 wherein the impurity migration preventing thickness of the ceramic coating is nominally 60 microns thick.

8. The wafer boat of Claim 1 wherein the ceramic coating has a purity level of substantially 1 ppm or less.

9. The wafer boat of Claim 1 wherein the wafer boat is a vertical wafer boat.

10. The wafer boat of Claim 2 comprising:
a generally horizontal base (14);
a support rod (12) extending generally vertically from the base and having at least a pair of arms (32, 33) extending generally parallel relative to the base, the pair of arms defining the at least one wafer slot.

11. The wafer boat of Claim 10 wherein the support rod comprises a plurality of arms defining a plurality of slots each sized to receive a silicon wafer, each slot having the ceramic coating disposed thereon to define a plurality of wafer contact surfaces, each wafer contact surface having the post coating surface finish.

12. The wafer boat of Claim 10 wherein the support rod comprises a plurality of support rods.

13. The wafer boat of Claim 10 comprising a top plate (16) attached to the upper distal end (30) of the support rod.

14. The wafer boat of Claim 10 wherein the base comprises a stress relief slot (22) and a location notch (26).

15. A method of making a wafer boat for supporting silicon wafers, the method comprising:
providing a ceramic wafer boat body having at least one wafer support structure (32, 33) sized to support a silicon wafer thereon;
coating (94) a surface of the wafer support structure with a protective ceramic coating (36); and
finishing (96) the protective ceramic coating to define a wafer contact surface (38), the protective ceramic coating having a thickness of substantially 30 microns or greater to prevent impurity migration, and the wafer contact surface having a post coating surface finish, wherein the post coating surface finish substantially prevents slip in the silicon wafers and has a post coating surface finish of less than or substantially equal to 0.4 microns.

16. The method of Claim 15 wherein coating comprises a chemical vapor deposition (CVD) process.

17. The method of Claim 15 wherein finishing comprises one of a machining operation and a laser cutting operation.

18. The method of Claim 15 wherein providing comprises providing one of a quartz body, a SiC body and a recrystallized SiC body.

19. The method of Claim 15 wherein coating comprises coating with SiC.

20. The method of Claim 15 wherein finishing comprises finishing the ceramic coating to an impurity migration preventing thickness of 60 microns nominal.

21. The method of Claim 15 wherein coating comprises coating with a ceramic coating having a purity level of less than or substantially equal to 1 ppm.

22. The method of Claim 15 comprising:
dimensionally undersizing the critical dimensions of the ceramic body by a predetermined amount; and
compensating for the undersized critical dimensions by the predetermined thickness of the protective coating applied.

23. The method of Claim 15 comprising:
processing (72) SiC in molds to produce a set of green body parts, which include a plurality of support rods (12), a base (14) and a top plate (16);
subjecting (74) the set of body parts to a recrystallization process;
assembling (84) the set of body parts to form the unfinished ceramic body;
impregnating (86) the ceramic body with high purity silicon metal;
sandblasting (88) the ceramic body;
machining (90) of the ceramic body;
CVD coating the entire body with high purity SiC; and
post CVD finishing the ceramic body to define the wafer contact surfaces.

## Patentansprüche

1. Waferboot (10) zum Halten von Siliziumwafern, wobei das Waferboot Folgendes umfasst:
einen Keramikkörper mit zumindest einem Waferhalteaufbau (32, 33), der eine derartige Größe aufweist, dass er auf sich einen Siliziumwafer hält;
eine Keramikbeschichtung (36), die auf einer Fläche des Waferhalteaufbaus angeordnet ist, wobei die Keramikbeschichtung eine Dicke, die eine Wanderung von Verunreinigungen verhindert, und eine Waferkontaktfläche (38) aufweist, **dadurch gekennzeichnet, dass** die Waferkontaktfläche eine Oberflächenvergütung nach der Beschichtung aufweist;
wobei die Dicke der Keramikbeschichtung größer als eine Dicke von 30 Mikron oder dieser im Wesentlichen gleich ist, und die Oberflächenvergütung nach der Beschichtung der Waferkontaktfläche weniger als oder im Wesentlichen gleich 0,4 Mikron beträgt.

2. Waferboot nach Anspruch 1, wobei der Waferhalteaufbau zumindest einen Waferschlitz (34) umfasst, der eine derartige Größe aufweist, dass er darin einen Wafer aufnimmt.

3. Waferboot nach Anspruch 1, wobei die Oberflächenvergütung nach der Beschichtung der Waferkontaktfläche ein Rutschen in Siliziumwafern mit einem Durchmesser von 300 mm oder mehr im Wesentlichen verhindert.

4. Waferboot nach Anspruch 1, wobei die Oberflächenvergütung nach der Beschichtung der Waferkontaktfläche ein Rutschen in Siliziumwafern während Wärmearbeiten, die Temperaturen von 720 Grad Celsius oder höher erreichen, im Wesentlichen verhindert.

5. Waferboot nach Anspruch 1, wobei der Keramikkörper eines von Quarz, Siliziumcarbid (SiC) und rekristallisiertem SiC umfasst.

6. Waferboot nach Anspruch 1, wobei die Keramikbeschichtung ein SiC umfasst.

7. Waferboot nach Anspruch 1, wobei die eine Wanderung von Verunreinigungen verhindernde Dicke der Keramikbeschichtung nominell 60 Mikron dick ist.

8. Waferboot nach Anspruch 1, wobei die Keramikbeschichtung einen Reinheitsgrad von im Wesentlichen 1 ppm oder weniger aufweist.

9. Waferboot nach Anspruch 1, wobei das Waferboot ein senkrechtes Waferboot ist.

10. Waferboot nach Anspruch 2, umfassend:
eine im Allgemeinen waagerechte Basis (14);
eine Haltestange (12), die sich im Allgemeinen senkrecht von der Basis erstreckt und zumindest ein Paar von Armen (32, 33) aufweist, die sich in Bezug auf die Basis im Allgemeinen parallel erstrecken, wobei das Paar von Armen den zumindest einen Waferschlitz definiert.

11. Waferboot nach Anspruch 10, wobei die Haltestange mehrere Arme umfasst, die mehrere Schlitze definieren, welche jeweils eine derartige Größe aufweisen, dass sie einen Siliziumwafer aufnehmen, wobei die Keramikbeschichtung auf jedem Schlitz angeordnet ist, um mehrere Waferkontaktflächen zu definieren, wobei jede Waferkontaktfläche die Oberflächenvergütung nach der Beschichtung aufweist.

12. Waferboot nach Anspruch 10, wobei die Haltestange mehrere Haltestangen umfasst.

13. Waferboot nach Anspruch 10, umfassend eine obere Platte (16), die am oberen distalen Ende (30) der Haltestange angebracht ist.

14. Waferboot nach Anspruch 10, wobei die Basis einen Spannungsentlastungsschlitz (22) und eine Platzierungskerbe (26) umfasst.

15. Verfahren zur Herstellung eines Waferboots zum Halten von Siliziumwafern, wobei das Verfahren Folgendes umfasst:
Bereitstellen eines Keramik-Waferbootkörpers mit zumindest einem Waferhalteaufbau (32, 33), der eine derartige Größe aufweist, dass er auf sich einen Siliziumwafer hält;
Beschichten (94) einer Fläche des Waferhalteaufbaus mit einer schützenden Keramikbeschichtung (36); und
Fertigbearbeiten (96) der schützenden Keramikbeschichtung, um eine Waferkontaktfläche (38) zu definieren, wobei die schützende Keramikbeschichtung eine Dicke von im Wesentlichen 30 Mikron oder mehr aufweist, um eine Wanderung von Verunreinigungen zu verhindern, und die Waferkontaktfläche eine Oberflächenvergütung nach der Beschichtung aufweist, wobei die Oberflächenvergütung nach der Beschichtung ein Rutschen in den Siliziumwafern im Wesentlichen verhindert und eine Oberflächenvergütung nach der Beschichtung von weniger als oder im Wesentlichen gleich 0,4 Mikron aufweist.

16. Verfahren nach Anspruch 15, wobei das Beschichten einen chemischen Dampfphasenabscheidungs(CVD)prozess umfasst.

17. Verfahren nach Anspruch 15, wobei das Fertigbearbeiten entweder eine Bearbeitungstätigkeit oder eine Laserschneidetätigkeit umfasst.

18. Verfahren nach Anspruch 15, wobei das Bereitstellen ein Bereitstellen eines von einem Quarzkörper, einem SiC-Körper und einem rekristallisierten SiC-Körper umfasst.

19. Verfahren nach Anspruch 15, wobei das Beschichten ein Beschichten mit SiC umfasst.

20. Verfahren nach Anspruch 15, wobei das Fertigbearbeiten ein Fertigbearbeiten der Keramikbeschichtung zu einer Dicke, die eine Wanderung von Verunreinigungen verhindert, von nominell 60 Mikron umfasst.

21. Verfahren nach Anspruch 15, wobei das Beschichten ein Beschichten mit einer Keramikbeschichtung mit einem Reinheitsgrad von weniger als oder im Wesentlichen gleich 1 ppm umfasst.

22. Verfahren nach Anspruch 15, umfassend:
dimensionales Unterbemessen der kritischen Abmessungen des Keramikkörpers um ein vorherbestimmtes Ausmaß; und
Ausgleichen der unterbemessenen kritischen Abmessungen durch die vorherbestimmte Dicke der aufgebrachten schützenden Beschichtung.

23. Verfahren nach Anspruch 15, umfassend:
Bearbeiten (72) von SiC in Formen, um einen Satz von Grünkörperteilen herzustellen, die mehrere Haltestangen (12), eine Basis (14) und eine obere Platte (16) beinhalten;
Unterziehen (74) des Satzes von Körperteilen einem Rekristallisierungsprozess;
Zusammensetzen (84) des Satzes von Körperteilen, um den nicht fertigbearbeiteten Keramikkörper zu bilden;
Imprägnieren (86) des Keramikkörpers mit einem Siliziummetall mit hoher Reinheit;
Sandbestrahlen (88) des Keramikkörpers;
Bearbeiten (90) des Keramikkörpers;
CVD-Beschichten des gesamten Körpers mit SiC mit hoher Reinheit; und
Endvergüten des Keramikkörpers nach der CVD, um die Waferkontaktflächen zu definieren.

## Revendications

1. Nacelle de plaquettes (10) pour supporter des plaquettes de silicium, la nacelle de plaquettes comprenant :
un corps céramique comportant au moins une structure de support de plaquette (32, 33) dimensionnée pour y supporter une plaquette de silicium ;
un revêtement céramique (36) disposé sur une surface de la structure de support de plaquette, le revêtement céramique ayant une épaisseur empêchant la migration des impuretés et une surface de contact de plaquette (38), **caractérisé en ce que** la surface de contact de plaquette comporte un fini de surface post-revêtement ;
dans laquelle l'épaisseur du revêtement céramique est supérieure ou sensiblement égale à 30 µm, et le fini de surface post-revêtement de la surface de contact de plaquette est inférieur ou sensiblement égal à 0,4 µm.

2. Nacelle de plaquettes selon la revendication 1 dans laquelle la structure de support de plaquette comprend au moins une fente pour plaquette (34) dimensionnée pour y recevoir une plaquette de silicium.

3. Nacelle de plaquettes selon la revendication 1 dans laquelle le fini de surface post-revêtement de la surface de contact de plaquette empêche sensiblement le glissement de plaquettes de silicium de 300 mm de diamètre ou plus.

4. Nacelle de plaquettes selon la revendication 1 dans laquelle le fini de surface post-revêtement de la surface de contact de plaquette empêche sensiblement le glissement de plaquettes de silicium lors d'opérations thermiques atteignant des températures de 720 degrés Celsius ou plus.

5. Nacelle de plaquettes selon la revendication 1 dans laquelle le corps céramique comprend du quartz ou du carbure de silicium (SiC) ou du SiC recristallisé.

6. Nacelle de plaquettes selon la revendication 1 dans laquelle le revêtement céramique comprend du SiC.

7. Nacelle de plaquettes selon la revendication 1 dans laquelle l'épaisseur empêchant la migration des impuretés du revêtement céramique prend une valeur nominale de 60 µm.

8. Nacelle de plaquettes selon la revendication 1 dans laquelle le revêtement céramique a un niveau de pureté sensiblement de 1 ppm ou moins.

9. Nacelle de plaquettes selon la revendication 1, la nacelle de plaquettes étant une nacelle de plaquettes verticale.

10. Nacelle de plaquettes selon la revendication 2 comprenant :
un socle généralement horizontal (14) ;
une tige de support (12) s'étendant généralement verticalement depuis le socle et comportant au moins une paire de bras (32, 33) s'étendant généralement parallèlement au socle, la paire de bras définissant l'au moins une fente pour plaquette.

11. Nacelle de plaquettes selon la revendication 10 dans laquelle la tige de support comprend une pluralité de bras définissant une pluralité de fentes, chacune dimensionnée pour recevoir une plaquette de silicium, chaque fente ayant le revêtement céramique disposé pardessus pour définir une pluralité de surfaces de contact de plaquette, chaque surface de contact de plaquette comportant le fini de surface post-revêtement.

12. Nacelle de plaquettes selon la revendication 10 dans laquelle la tige de support comprend une pluralité de tiges de support.

13. Nacelle de plaquettes selon la revendication 10 comprenant une plaque supérieure (16) fixée à l'extrémité distale supérieure (30) de la tige de support.

14. Nacelle de plaquettes selon la revendication 10 dans laquelle le socle comprend une fente de relaxation des contraintes (22) et une encoche de positionnement (26).

15. Procédé de fabrication d'une nacelle de plaquettes pour supporter des plaquettes de silicium, le procédé comprenant :
l'obtention d'un corps de nacelle de plaquettes en céramique comportant au moins une structure de support de plaquette (32, 33) dimensionnée pour y supporter une plaquette de silicium ;
le recouvrement (94) d'une surface de la structure de support de plaquette avec un revêtement céramique protecteur (36) ; et
la finition (96) du revêtement céramique protecteur pour définir une surface de contact de plaquette (38), le revêtement céramique protecteur ayant une épaisseur sensiblement de 30 µm ou plus pour empêcher la migration des impuretés, et la surface de contact de plaquette comportant un fini de surface post-revêtement, le fini de surface post-revêtement empêchant sensiblement le glissement des plaquettes de silicium et étant inférieur ou sensiblement égal à 0,4 µm.

16. Procédé selon la revendication 15 dans lequel le recouvrement comprend un procédé de dépôt chimique en phase vapeur (CVD).

17. Procédé selon la revendication 15 dans lequel la finition comprend une opération d'usinage ou une opération de découpe au laser.

18. Procédé selon la revendication 15 dans lequel l'obtention comprend l'obtention d'un corps de quartz ou d'un corps de SiC ou d'un corps de SiC recristallisé.

19. Procédé selon la revendication 15 dans lequel le recouvrement comprend un recouvrement avec du SiC.

20. Procédé selon la revendication 15 dans lequel la finition comprend une finition du revêtement céramique à une épaisseur empêchant la migration des impuretés de 60 µm nominaux.

21. Procédé selon la revendication 15 dans lequel le recouvrement comprend un recouvrement avec un revêtement céramique ayant un niveau de pureté inférieur ou sensiblement égal à 1 ppm.

22. Procédé selon la revendication 15 comprenant :
le sous-dimensionnement des dimensions critiques du corps céramique d'une quantité prédéterminée ; et
la compensation des dimensions critiques sous-dimensionnées par l'épaisseur prédéterminée du revêtement protecteur appliqué.

23. Procédé selon la revendication 15 comprenant :
la transformation (72) de SiC en moules pour produire un ensemble de pièces de corps vertes, qui comprend une pluralité de tiges de support (12), un socle (14) et une plaque supérieure (16) ;
la soumission (74) de l'ensemble de pièces de corps à un procédé de recristallisation ;
l'assemblage (84) de l'ensemble de pièces de corps pour former le corps céramique non fini ;
l'imprégnation (86) du corps céramique avec du silicium métallique de haute pureté ;
le sablage (88) du corps céramique ;
l'usinage (90) du corps céramique ;
le recouvrement par CVD de la totalité du corps avec du SiC de haute pureté ; et
la finition post-CVD du corps céramique pour définir les surfaces de contact de plaquette.
